# EUROPEAN PATENT APPLICATION

(11) **EP 4 365 615 A1**
(43) Date of publication of application: **08.05.2024**
(21) Application number: 22205747.3
(22) Date of filing: 07.11.2022
(51) Int. Cl.: G01R 33/36, G01R 33/54

(54) **RF RECEIVER ASSEMBLY WITH INTEGRATED CALIBRATION METHOD**

(71) Applicant: Koninklijke Philips N.V., 5656 AG Eindhoven (NL)
(72) Inventor: VERNICKEL, Peter, Eindhoven (NL); LEUSSLER, Christoph Günther, Eindhoven (NL); FINDEKLEE, Christian, 5656AG Eindhoven (NL)
(74) Representative: Philips Intellectual Property & Standards

(57) **Abstract**

A radio frequency (RF) receiver assembly (100) for use in a magnetic resonance imaging (MRI) system is described. The receiver assembly (100) comprises a primary resonant circuit (101) coupled to a preamplifier (106) via capacitive coupling, and a secondary resonance circuit (104) comprising of at least one inductor (104a) coupled between a first switch (103) and the capacitive coupling. The first switch (103) is circuited between the primary (101) and the secondary (104) resonant circuits, and the preamplifier (106).

## Description

### FIELD OF THE INVENTION

The invention relates to Magnetic Resonance Imaging, in particular to radio frequency coils (RF coils) for magnetic resonance imaging.

### BACKGROUND OF THE INVENTION

Characterization of MRI parameters and fields used in scanned sequeces remains a challenge in the field of MRI equiment. There are many parameters, imperfections of the system, inhomogenities of the coils, as well as artifacts of the system and patient that can influence the making of a quality scan in the machine. One way to mitigate this is to have precise measurements of the fields exhibited by the MRI system. Conventionally, a sepaparate field probe system is used for measurements in relation to artifacts.

Furthermore, gradient imperfections can create multitude of different artifacts in the clinical practice, which creates geometric and intensity distortions influencing clinical practice. This can include incorrect image warping, reduced sensitivity and noise, flame artifacts, backfolding artifacts, spike artifact among others. One way to mitigate this is to locate coils based on gradient imperfections ("Theory of Gradient Coil Design Methods for Magnetic Resonance Imaging", Hidalgo Tobon et. Al., July 2010) , but this is time consuming and costly, prone to errors, may create additional artifacts among others.

It is often needed to correctly characterized the RF receiver assembly parameters, such as radiofrequency (RF) field. However, it is a challenging task to do in-practice. For instance, continued application of the B₁ field results in progressive tipping of the net magnetization away from its initial alignment with Bo, which affects the image quality and may create artifacts in the image. Characterization of fields often comes from the assumption that the fields are static, which is not the case in-practice.

RF coils often provide a lot of useful information on the actual characterization of the fields, but they are imprecise, cannot correct for all the artifacts, and create challenges in field characterization.

Hence, there is a need for better correction of the artifacts in the clinical practice.

Recent development of integrated circuits has brought up a new generation of switching devices with interesting properties for MRI devices. Single pole dual throw devices are available with very small footprint, affordable prices and with convincing RF parameters so that those can directly be integrated into MR coil resonators. However, these devices were not yet integrated in the MR machines and/or used for clinical practice. Especially this was not done for correction of artifacts and/or sensing of additional parameters.

Conventional systems like the one described in *"*A Field Camera for MR Sequence Monitoring and System Analysis", by B.Dietrich et.al., is using a flexible NMR field probe-based stand-alone monitoring system, built on a software-defined-radio approach.

### SUMMARY OF THE INVENTION

The invention is defined by the claims. Dependent claims represent beneficial embodiments of the invention.

MRI exhibits the need for exact characterization of the electromagnetic fields involved, e.g. B1, B0 and gradient fields. This is done for exact characterization of the fields and subsequent correction of the scan parameters. With precise characterization and known exhibited paramteres of the fields, local imperfections can be corrected by predistortion or in post processing. For instance, exact knowledge of the B 1 fields allows for better RF shimming or a more exact determination of the specific absorption rate (SAR) levels, which remains a difficult and imprecise task. This applies also to Ultra-fast MR imaging systems.

Developing a radiofrequency (RF) coil system that produces a uniform B₁ and B₀ fields and low specific absorption rate (SAR) is critical for high performance MRI systems, such as ultrahigh field MR systems. Furthermore, to allow to reduce artifacts and increase acceleration of the acquisition parameters.

According to examples in accordance with an aspect of the invention, a radio frequency RF receiver assembly (RF receiver assembly or just coil assembly within the context of the present application) for use in a magnetic resonance imaging (MRI) system is provided, the RF receiver assembly comprising:
a primary resonant circuit coupled to a preamplifier via capacitive coupling,
and a secondary resonance circuit comprising of at least one inductor coupled between a first switch and the capacitive coupling,
wherein the first switch is circuited between the primary and the secondary resonant circuits, and the preamplifier.

The secondary circuit is configured to sense electromagnetic fields in the magnetic resonance examination system's examination zone, such as the main magnetic field, the B1-excitation field and gradient magnetic fields. The signals representing the electromagnetic (EM) field maps can be read-out over the pre-amplifier. The primary and secondary circuits are switchable over the switch and connected to the preamplifier. On the basis of the acquired EM field maps, and in some embodiments by using machine learning for calculations, the imaging parameters may be adjusted. One of the advantages of the invention is that it enables to dynamically lower image artefacts and increase acceleration of the MR acquisition. Hence, there is no need to engage field camera as the field mapping measuremenets are integrated in RF coils.

Given an RF coil, the preamplifier is the most expensive part and it is not used to at full capacity. One of the aspects of the present invnetion is to enable the use of the preamplifier during idle time for additional purposes such as B0 mapping. One of the additional aspects of the invention is to use a secondary circuit for reducing the number of components needed (as it will reduce the number of stand-alone components), and will allow to make more precise measurements. Recently available technology (microscopically small switches with very good RF features at affordable prices) and the insights of this patent applciation enable several options for additional calibration.

In one example, the secondary resonant circuit further comprises of at least one capacitor or attenuator connected in-series to the inductor. In some embodiments, the capacitor or attenuator may be connected in-parallel.

In some other examples, multiple capacitors or attenuators can be used in combination in the secondary circuit for filtering unwanted signals or frequencies. A practical example is given explaining the principle of this embodiment. Next to the desired signal, the secondary circuit will pick up other undesired signals. Those can originate from the basic function of the MR system. For intance, imagine you want to characterize gradient fields with <20kHz, the secondary circuit will then pick-up the Larmor frequency for spin excitation as an undesired singal, or the secondary circuit can pick-up spurious emissions from defect or incompatible accessory devices. Hence, by using multiple capacitors or attenuators, the filtering using known high-, low- or band pass structures as well as resistive attenuators, can be measured separately, and hence, the unwanted signals can be alleviated.

In another example, the RF resonant circuit can contain, in addition to the inductor, at least one and preferably two, additional inductors with a matching pair of capacitors can be used, which are connected in-series to the first switch. In a preferred example, 3 pairs of inductors-capacitors can be used for filtering the X-, Y-, Z- components of the field.

In some examples of the present invention, more than one switch can be used in the circuity of the RF receiver assemblyconnected to the preamplifier. For instance, a second switch can be used, wherein the second switch is capacitively coupled to the primary circuit and capacitively coupled to the preamplifier, wherein the secondary circuit is circuited between the first and second switches.

Capacitive coupling can refer to transfer of energy between different circuit nodes induced by the electric field. Often, capacitive coupling would include a capacitor in the circuitry between the nodes. The term "circuited" may mean creating a closed path through which an electric current flows or may flow.

In some examples of the present invention, the wherein the signal from the primary resonant circuit can be tailored to match to the signal of the preamplifier. Tailored may mean: substantially matched between the parts of the circuit, equating the signal from the primary circuit to the preamplifier, or otherwise balancing the current from the RF receiver assemblytowards the preamplifier.

In some examples, the RF coil's secondary resonance circuit is configured to measure at least one of: B0, B1, predistortions, Nuclear Magnetic Resonance signals (NMR signals), gradient values, and calculate the deviations from demand values and with it predict the the expected artifact level based on the measurements. The data from the measurements may be used to calculate the artifact level, which is expected for different MRI sequences. Furthermore, an artifact threshold can be applied to the expected artifact level. In some embodiments this can be done using a comparator. This can help guiding and proposing acceleration or compression factors for imaging sequence to prevent image artifacts. The artifact threshold can also be used for automatically filtering the images not meeting a certain artifact threshold and either adjusting the scan protocol based, or displaying and error message, or both.

The RF receiver assembly described in the current invention can be adapted for use in an MRI machine. In one aspect of the present invention, an MRI machine is claimed that adapted for use of the RF coils of the present invention. Any MR system can be used in the context of the present invention, such as: low-field MR system, conventional clinical MR systems (like 1.5T, 3.0T), Research-oriented MRI systems (like 7.0T systems), functional MRI (fMRI systems). The skilled practitioner would understand that both closed bore and open bore systems can be used in the context of the present invention.

In some exmples, the MRI system can be adapted to automatically adjust the scan sequences imaging parameters based on the measurements of the secondary resonant circuit of RF receiver assemblyof the present invention and the expected artifact level. For instance, if the expected artifact level is too big for a given sequence, the MR sequence can be adjusted.

In some examples, the Magnetic Resonance Imaging (MRI) system further comprises a Machine Learning (ML) algorithm, such as but not limited to a trained Neural Network, that can be used for analyzing/adjusting of sequences and/or measurements of the secondary resonant circuit. In some embodiments, the ML algorithm is trained based on the data from the RF receiver assembly and the measurements from the secondary resonant circuits. In some other embodiments training of the ML algorithm is based on the sequence information from the MR machine.

In some examples, a Magnetic Resonance Imaging (MRI) system is provided, wherein the measurements of the secondary resonant circuit can be used for at least one of: for calibration of the gradients, predistortion correction or other MR sequence correction purposes. The skilled person would realize that multitude of different correction options can be used in an MR system. The reason being that there are many different reasons for an artifact produced by an MRI system. The skilled person would realize that ehse are main corrections to be done in relation to B₀/B₁ fields, but others are possible.

In some examples, a method of operation of an MRI system and/or RF coils according to the present invention is described.

In some examples, a computer program comprising instructions which, when the program is executed by a computer, cause the computer to carry out the method or being configured to run on the MRI system. Furthermore, a data carrier signal carrying the computer program is described. In some embodiments, A computer-readable storage medium comprising instructions which, when executed by a computer, cause the computer to carry out the method of the present application is described.

The one of ordinary skill in the art would understand that normally an RF receiver assembly is directly connected to a preampmlifier with a matching circuit. Use of a second optional circuit loop, which can be connected to the inputs of the preamplifier (-s) while the RF receiver assembly itself is disconnected, can bring certain technical advantages. For instance, this allows to enable a small coil with very localized sensitivity profile on demand.

One of the advantages of the present invention is that more efficient calibration and correction of the imaging sequences can be achieved due to measurements done by the secondary circuit.

Another advantage redides in the fact that the amount of needed hardware can be reduced since the secondary coil loop is integrated/couped to the receiver assembly. One would not need separate equipment to measure the MR field, and it may be integrated in the radiofrequency chain.

Another advantage is that due to more efficient B₁ measurements, better RF shimming or a more exact determination of SAR levels can be achieved.

Another advantage is that the imaging artifacts of the system can be reduced to more efficient scanning protocols. Furthermore, the artifacts can be reduced by adaptation of the scanning sequence parameters (e.g. acceleration or compression).

Another advatange is that the sensitivity of the measurements of the fields (e.g. B₀, B₁, gradients) can be improved due to e.g. a secondary resonant circuit.

Another advantage is that the flip angle can be reduced. Furthermore, if the measured signal is too low, this might indicate the there are problems in the system, which will allow to better diagnose system failures.

Another advantage is that more efficient scanning protocols can be achieved since the system can automatically control and/or propose changes to the scanning protocols based on e.g. threshold level for the artifacts.

Another advantage could be in possiblity of sensing the B1 field while transmiting and/or sensing the gradients intermittend to transeiver and receiver phases.

Another advantage is that the processing time is reduced by using the coil assembly of the present invention.

Another advantage is that the system can make more precise measurement in view of the secondary resonant circuit.

Other advantages can be envisaged to the person of the ordinary skill in the art within the context of the present invention.

### BRIEF DESCRIPTION OF THE DRAWINGS

For a better understanding of the invention, and to show more clearly how it may be carried into effect, reference will now be made, by way of example only, to the accompanying drawings, in which:
Fig. 1 shows a basic RF receiver assembly according to the present invention having a coil loading for bandwidth adjustment.
Fig. 2 shows an RF receiver assembly according to the present invention, wherein the primary circuit is directly connected to the switch.
Fig. 3 shows an RF coil, wherein a secondary circuit is placed directly inside the primary circuit.
Fig. 4 shows an RF receiver assembly example, wherein multiple secondary circuits can be used for measurements of parameters.
Fig. 5 shows an RF receiver assembly example, wherein multiple switches can be used.
Fig. 6 shows an example of a sequencing protocol employing the RF receiver assembly of the present invention.

### DETAILED DESCRIPTION OF EMBODIMENTS

The invention will be described with reference to the figures. The person of ordinary skill in the art would understand that further embodiments may be possible within the context of the present invention.

The detailed description and specific examples, while indicating exemplary embodiments of the apparatus, systems, and methods, are intended for purposes of illustration only and are not intended to limit the scope of the invention. These and other features, aspects, and advantages of the apparatus, systems and methods of the present invention will become better understood from the following description, appended claims, and accompanying drawings. The figures are merely schematic and are not drawn to scale. It should also be understood that the same reference numerals are used throughout the figures to indicate the same or similar parts.

The invention provides an RF receiver assemblyassembly that can be used for performing measurements on the operation of an MR machine. Corresponding method, computer program, data signal, and computer-implemented media are described in relation to the RF receiver assemblyassembly.

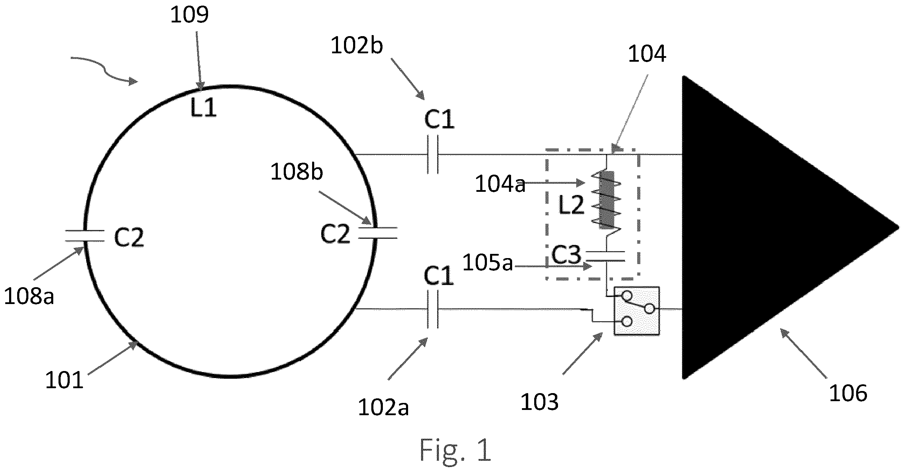

Fig. 1 describes a radio frequency RF receiver assembly [RF coil assembly, coil assembly] (100) for use in a magnetic resonance imaging (MRI) system is described. The RF receiver assembly (100) comprises a primary resonant circuit (101) coupled to a preamplifier (106) via capacitive coupling. Furthermore, the RF receiver assembly has the secondary resonance circuit (104) comprising of at least one inductor (104a) coupled between a first switch (103) and the capacitive coupling. The first switch (103) is circuited between the primary (101) and the secondary (104) resonant circuits, and the preamplifier (106).

Capacitive coupling within the context of the present invetion may mean any coupling, wiring or other connection that includes a capacitor. The capacitor could be of any type that is suited for application in a circuit, which includes, but not limited to, ceramic capacitors, electrolytic capacitors, film and paper capacitors, super capacitors, glass capacitors, air-gap capacitors, silicon capacitors, silver mica capacitors, high-capacitance multilayer ceramic chip capacitors (MLCC's), H-Chips, V-Chips, and others. Other connection types, like resistive connection, may be possible within the context of the present applciation. Preamplifier 106 (also known as preamp), can include any electronic amplifier for outputting signal strong enough for further processing of the signal. The person skilled in the art would understand that "preamlfiier" has a broad meaning and can include additional components, such as sensors, as well as different amplifier types.

RF receiver assembly (100) within the context of the present invention comprises any RF coil, general RF coil or dedicated RF coil (e.g. for specific applications), that can be used within an MRI machine. An RF receiver assembly may be e.g. a resonant RLC circuit (resistance R, inductance L, capacitance C) tuned to the Larmor frequency of interest and matched to the input impedance of the MR scanner. The assembly is a general/generic word and may contain multiple additional components needed for a RF coil assembly. It is known, that RF coils directly impact the spatial and temporal resolutions, sensitivity, and unifromity in MRI.

Capacitor or attenuator (105a) in Fig. 1 stands for a resonance capacitor, a full matching circuit or an attenuator to tailor the signal level within the specific application and preamplifier dynamic range. In some embodiments the capacitor or attenuator may be integrated in the secondary resonant circuit (104). In some other embodiments, the capacitor or attenuator (105a) may be omitted.

First primary resonant circuit (101) may mean a first circuit loop within the context of an MR machine. The first primary resonant circuit (101) coild be of a single loop coil (SLC) or a multi-loop coil (MLC) type. The skilled person would understand that MLC's refer to the association of small loops in series that result in a single coil element composed of multiple loops. Hence, the first primary resonant circuit (101) means a first single coil element within the context of the present invention. A secondary resonance circuit (104) may be coupled to the first coil element. The second coil element may analogously be of SLC or MLC type. The two coils corresponding primary resonant circuit (101) and secondary resonant circuit (104) could be used in any combination, for instance, a primary resonant circuit (101) of MLC type and secondary resonant circuit of SLC type. The skilled person would understand that both a primary circuit (101) and the secondary circuit (104) may include any approapriate elements so that both circuits function as an RLC circuit. For instance, the primary resonance may include an at least one capacitor (108a, 108b) and an inductor (109), wherein the secondary circuit may include at least one inductor (104a) and a capacitor (105a).

In the context of the present invention, switch (103, 103a) may incldue any types of switches, especially suited for MRI applications. Non-limiting examples may includes Power metal oxide semiconductor field effect transistors (MOSFETs), radio-frequency-activated switching systems, micro•electromechanical systems (MEMS), PIN diodes, radiofrequency switches, and others. The switch could be of single pole (SP), dual pole (DP), Double Pole Single Throw (DPST), Double Pole Double Throw (DPDT), Single Pole Double Throw switch (SPDT) switch types. Other types within the context of the present invention may be envisioned. Preferably, the switch used is of the type that can be directly integrated into the MR coil RF coils. One such preferred example is of SPDT type.

The person of ordinary skill in the art would understand that the primary resonant coil (101)/RF receiver assembly(101) may perform the typical fucntions of an RF receiver assembly within the MRI equipment. This may include working as "antennas", wherein the RF coils are configured to excite the magnetization by broadcasting the RF power (transmit, Tx•Coil) and second to receive the signal from the excited spins (receive, Rx•Coil). Generally, the RF coils are responsible for detecting the MR signal. They directly impact the spatial and temporal resolution, sensitivity, and uniformity in MRI. However, the measured signal may have distortions and/or may be too low for detection. Due to the precession around the static main magnetic field, the magnetic flux in the RF receiver assembly ( B1-) changes, which generates a current I. This signal is "picked-up" by an antenna and preamplified, usually mixed down to a lower frequency, digitized, and processed by a computer to finally reconstruct an image or a spectrum. Transmit and receive functionality can be combined in one RF receiver assembly(Tx/Rx Coils). However, one of the common problems as was mentioned, that the signal may be too low for detection and/or be distorted and/or be measured incorrectly. On the other hand, the exact characterization of the electromagnetic fields involved (B₀, B₁, grandient fields) is quite important, which might allow to correct the local imperfections in a more presice manner. Furthermore, exact knowledge of the B1 fields allows for better RF shimming or a more exact determination of the SAR levels. Furthermore, coils can be located based on gradient imperfections to mitigate image artifacts (e.g. flame artifacts, backfolding artefacts).

One of the insights of the present invention is that by using a secondary resonant coil (104) in conjunction with a primary resonant coil (101) might give further advantages, such as characterization of magnetic fields or artefact correction. The secondary resonance coil (104) may act as an "antenna within the antenna". In other words, the secondary resonant circuit (104) may work as a sensor for detecting the signals coming from the primary resonant circuit (101). The secondary resonant circuit (104) may be of any type suitable for secondary circuit loop. The secondary resonant circuit (104) is connected to the primary circuit (101) and to the inputs of the preamplifier (106). As a non-limiting example, the secondary coil can be of a solenoid coil type, such as AC Laminated Solenoid, DC C-Frame Solenoid, DC D-Frame Solenoid, Linear Solenoid, Rotary Solenoid. As an example, the secondary resonant circuit (104) can be a solenoid filled with a small portion of fluid that emits Nuclear Magnetic Resonance (NMR) signals when being excited with a RF pulse of proper frequency.

One of the other insights of the present invetnion that if an inductor 104a L2 comes with its own capacitor 105a that can be configured for signal conditioning, at the input of the preamplifier 106 there is a switch 103, wherein the switch can be configured for analyzing and adapting which of the independent circuits 101, 102, or both, can to be connected to the preamplifier.

In some embodiment, a second analog preampilifer (not denoted in figures) matching to the needs of an inductor 104a and capacitor 105a can be used. In this case, the switch would be placed at the input of an digitizer (not denoted in figures) to decide which of the output signals of the amplifiers is digitized.

In some embodiments, the RF receiver assembly may be disconnected, swtiched off or otherwise decoupled from the MR machine while the secondary resonant circuit (104) performs the measurements. In some other embodiments, the secondary resonant circuit may operate in-parallel with the primary RF receiver assembly(100)/primary resonant circuit (101). As an example, if there is no need for calibration of the RF receiver assembly(100), the primary resonant circuit (101) will be connected to the preamplifier (106) directly omitting the connection to the secondary resonant circuit (104) by e.g. keeping the first switch (103) off. In case there is a need for calibration, the primary switch is being turned on, the secondary resonant circuit (104) gets connected in addition/instead of the primary resonant circuit (101). This may happen e.g. during a transmit phase (B₁ sensing) with in a normal MR sequence, during a dedicated, a dedicated preparation phase (sensing B₁, B₀ and gradient distortion), in a dedicated RF phase in an extended MR sequence (real time corrections). Any combination of these phases or inclusion of additional phases may be possible within the context of the present invention.

The fluid used in the exemplary solenoid of the secondary resonant circuit (104) may be of any fluid type used in solenoids suitable for an application in an MRI machine. The main requirement being that the liquid can facilitate the spins to resonate in the right bandwith. For instance, the fluid used can be tailored ot the task to be performed. As a non-limiting example, the fluid can be tailored to the needs of the calibration. In some embodiments, the fluid can be proton based (oil or water) doped with agents to adjust TI, T2, and the bandwidth of the MR coil. In some other embodiments, the fluid can be based on Fluorine (¹⁹F) or any other NMR substance so that the liquid does not interfere with proton imaging, the highly localized sensitivity of the solenoid and some residual sensitivity of the preamp at the specific non-proton frequency ensures that the calibration signal is high enough. Other examples of fluids for the secondary resonant circuit (104) may be possible.

The person of ordinary skill in the art would understand that the secondary resonant circuits (104) may be integrated in any type of RF coils, both rigid coils and flexible coils. Integrating the secondary resonant circuits (104) in rigid or flexible coils may have their own advantages. For instance, the integration into rigid coils may produce an additional advantage, since the spatial positions of the coils predetermined which is a prerequisite for position dependent field determination. In another example of flexible coils, the position of the receiveres can be determined using cameras.

In some embodiments, the secondary secondary resonant circuit (104) is configured to make measurements on the operation of the MR system based on radiofrequency (RF) pulses from the primary resonant circuit (101). This allows to characterize and/or correct the signal to the preamplifier by using the known pulses. Additionally or alternatively, this would allow to characterize the transmitter based on the known receiver signals.

In some embodiments, the circuit could be electrically reactive. "Electrically reactive" within the context of the present invention may mean a general/generic term, which could encompass capacitive and/or inductive and/or resistive couplings. The preferred embodiment is a capacitive coupling.

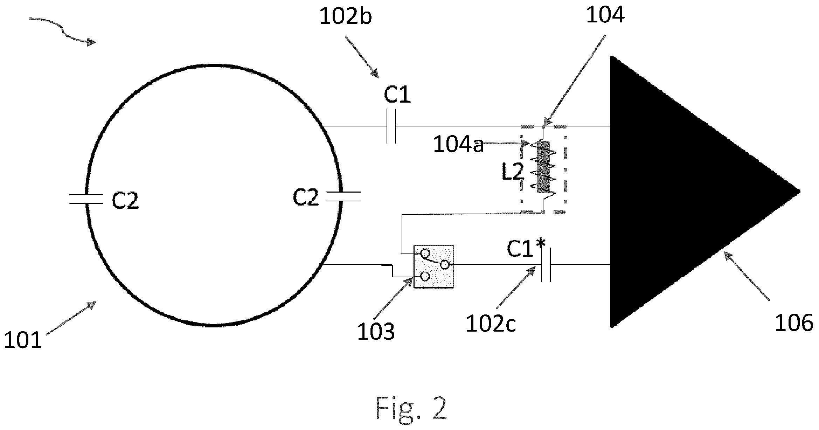

In some embodiments, the inductors of the present application (104a, 104b, 104c, 109) may be filled with a substance, that would allow to calibrate the MR machine. For instance, this could include air. In some other embodiments, the inductors of the present application may be filled with an MR sensitive material, or MR insensitive material. This can include, for instance, Deterium oxide, D2O, saline solution. By using such materials, the RF properties can be better tailored and/or additional properties can be measured within the context of the present application. The choice of the material depends on the actual applciation scenario (e.g. which parameter needs to be measured). Fig. 2 describes another embodiment of the present invention, wherein the the primary circuit is connected directly with the switch. In this cased the capacitor C1^{∗} (102c), also called as capacititive coupling within the context of the present invention, is directly connetected to the switch, in itself connected towards the primary (101) and secondary (104) circuits. The person of ordinary skill in the art would realize that in this case the capacitor 102c is part of the two loops: the loop created by the primary resonant circuit (101) and the loop created by the secondary resonant circuit (104). In some embodiments, the induction created by the inductor (104a) can be selected in a certain range, which provides for the means to establish the resonance condition of the RF coil. In other words, so that the circuits and the signals of the inductor (104a) matches to the RF receiver assembly (100). In some embodiments, the range could vary from 1 nH to 999 µH. Preferably, the range is in the orders of µH or nH. For instance, for measuring parameters in the RF domain, such as direct measurement of B 1 fields, measurement of B0, one would select an inductance of 104a in the order of 100nH. Another example, that for measurements in the lower frequency domain for gradient fields characterization or measurement of movement (voltage induction by the B0 field) one would select a inductance in the order of 100µH. There are many aspects for correctly selecting the range, such as the gradients, the system, the strength of the field, etc., so that these are non-limiting examples, and other frequencies than explicitly mentioned in the examples presented in details would be possible.

In some embodiments, using the same preamplifier 106 for both the RF receiver assembly 100 having a primary resonant frequency 101, and the secondary resonant circuit 104 having an inductor 104a, would lead to certain advantages. For instance, the inductor 104a could provide localized data, whereas the fields produced by the secondary resonant circuit 104 are not influencing the patient undergoing the MRI scan. By adapting the number of windings of the inductor 104a, the inductance can be altered so that induced signals in the secondary resonant circuit would match the order of magnituded of the signals of the primary resonant circuit 101.

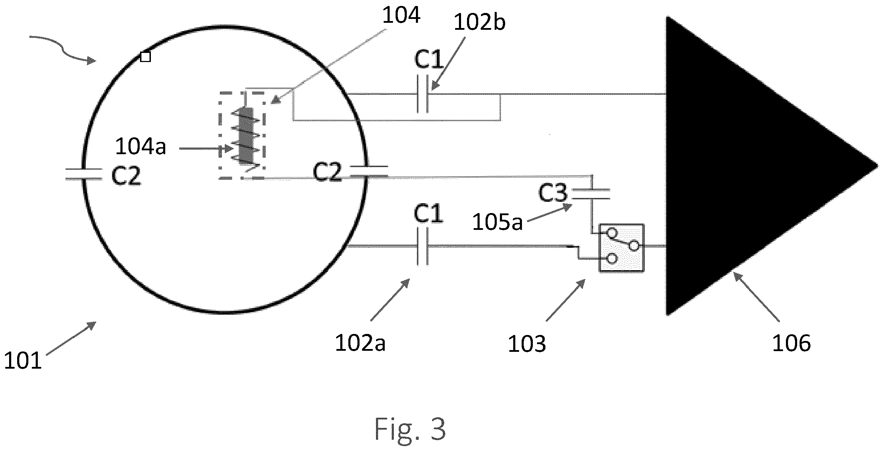

It is to be understood that by re-using the capacitor 102b for both the RF receiver assembly and the secondary resonant circuit 104, would allow to reduce the amount of hardware needed in the coil. In some embodiments, the capacitor 102c might be configured to be of such capacitance type to being able to perform the functions of other capacitors 102a, 102b. This might be beneficial in certain circuit and frequency types. In some embodiments it is also possible to relocate the inductor (104a) inside the primary circuit (101). A non-limiting example of this concept is shown in Fig. 3. Fig. 3 describes a radio frequency RF receiver assembly [RF coil assembly or coil assembly] (100) for use in a magnetic resonance imaging (MRI) system, wherein the RF receiver assembly (100) comprises a primary resonant circuit (101) coupled to a preamplifier (106) via capacitive coupling, and the RF receiver assembly has a secondary resonance circuit (104) comprising of at least one inductor (104a) ,wherein the first inductor (104a) is positioned inside the primary resonant circuit (101). The first switch (103) is circuited between the primary (101) and the secondary (104) resonant circuits, and the preamplifier (106). This embodiment has certain advantages such as being able to locate the RF receiver assembly 100 location.

MRI coils may be quite large and not circularly formed, which may mean that the preamplifier of an MR system may not be directly attached to the primary resonant circuit 101. Depending on the sensing task at hand (e.g. B₁, B₀ measurements) it could be important to locate the inductor's 104a location. This way, the possible location of the RF receiver assembly 100 could be achieved with more precision. It is to be understood, that the location of the preamplifier 106 could be determined instead in some embodiments. The actual impliementation depends on the realization and multiple options may be possible. In one embodiment, the inductor104 may contain some MRI active material, so by spatially encoding, one can find the probe in the bore of the MRI system, or, when conduscotr104 is configured to measure gradient fields it could be allocated by applying certain gradient wave-forms for localization.

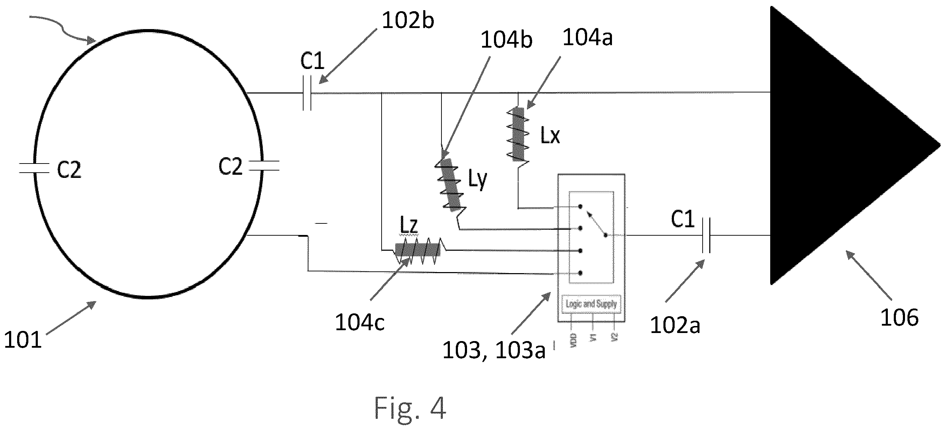

Fig. 4 describes another embodiment of the present application, wherein multiple secondary resonant circuits can be used. A non-limiting example is described below. Application of multiple secondary resonant circuits (104) can be applied to any embodiment/example of the present application.

Fig. 4 describes an exampe of an RF receiver assembly (100), wherein in addition to the inductor (104a) at least one, preferably two, additional inductors (104b, 104c) can be used. A corresponding/matching pair of capacitors (105a, 105b, 105c) can be coupled to the inductors, i.e. 104a to 105a, 104b to 105b, etc. In the example of Fig. 4, the RF receiver assembly (100) as described before, or with certain modifications suitable for the current embodiment, can be used. As an example, in some embodiments, the RF receiver assembly can be used with a switch (103). Further switches can be applied in some embodiments (denoted as 103a). For instance, a non-limiting example of a further switch that can be applied is a switch that has a logic and supply gates integrated in the switch. In some other examples, the logic and supply switch can be used in the previous embodiments of the application. Further examples that can be used within this or other embodiments, is a sink, DC-DC coupling, coupled logic switch, coupled emitter, and others. It would be beneficial if the switches (103, 103a) could switch between the secondary resonant circuits (denoted as inductors 104a, 104b, 104c). An advantage of this is the RF receiver assembly 100 could switch between the measurements of X-, Y-, Z- components of the B1 fields in a cartesian x-y-z coordinate systems. One of the advantages of this example is that the X-, Y-, Z-components of the field can be measured more effectively and/or diagnosing which part of the said components contributes most to the production of the artifacts. Hence, the artifacts can be corrected with more effiency and precision. The person of ordinary skill in the art would understand in the event that the B1 field is not tuned precisely to the Larmor frequency, it would not be stationary in the rotating frame. Correctly identifying the said component that contributes towards producing of artifacts would be quite beneficial to the RF coil.

In some embodiments, the measurements of the X-, Y-, Z- components is done in-parallel to each other. In other embodiments, the X-, Y-, Z- can be measured separately, for instance first measuring the X- component, then the Y- component and then the Z- component. In some embodiments, the inductors (104a, 104b, 104c) can be configured for measuring of different parameters. For instance, instead or in addition to measuring the X-, Y-, Z- components of the field, the inductors (104a, 104b, 104c) can be adapted for measuring e.g. power level (current), Larmor frequencies, matching amplitudes, field strengths, etc. The skilled person would understand that the magnetic fields (B₁, B₀, gradient) created by the MR machine can have multiple different parameters contributing to the field, and hence other paramater measurements can be performed by the inductors (104a, 104b, 104c). In some embodiments, more than two (104a, 104b) or 3 (104a, 104b, 104c) inductors in the secondary resonant circuit (104) can be deployed. For instance, there may be 6 inductors, wherein 3 inductors are measuring the X-, Y-, Z- components of the field and the other 3 inductors are measuring additional parameters like Larmor frequencies, power levels, etc.

It is to be understood that electromagnetic fields normally have an X-,Y-,Z- components and in some applications the X-, Y-, Z- components need to be characterized indepdentendly. With the help of at least one inductor 104a, 104b, 104c, the at least one inductor might be configured to measure at least one component. For instance, the inductor 104a may be used for measuring all three X-, Y-, Z-components. Alternatively, the inductor 104a may be used for measuring an X-component of the field, the inductor 104b may be used for measuring the Y-component of the field, the inductor 104c may be used for measuring the Z-component of the field. Other possible combinations (e.g. inductor 104a measuring X-, Z- components and inductor 104b measuring the Y-component) may be possible within the context of the invention. In some embodiments, the inductors 104a, 104b, 104c or additional inductors (e.g. 104d, 104e, 104f, not denoted) might be configured for measuring e.g. high inductance for measuring gradients, low inductance to form an RF receiver, and other parameters.

It is to be understood, the the inductors 104a, 104b, 104c, and the related capacitors 105a, 105b, 105c can be differently oriented depending on the MR system used. For instance, in some embodiments, the inductor 104a and the corresponding capacitor 105a can be oriented in X-direction (vertical), the inductor 104b and capacitor 105b can be oriented in Y-direction (oblique), the inductor 104c and capacitor 105c can be oriented in Y-direction (horizontal). In this case the measurements of the components are better aligned with the direction of the X-, Y-, Z- components, wherein better quality measurements can be obtained. However, other variations are possible, e.g. the inductors 104a, 104b, 104c and corresponding capacitors 105a, 105b, 105c can be oriented in e.g. X- direction, or Z-direction, which has an advantage in more easy production. Other arbitrary combinations depepending on the specific MR system are possible.

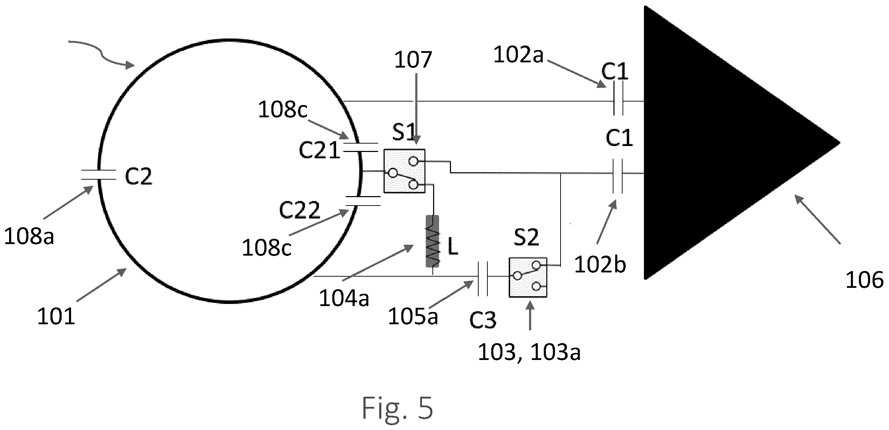

In some embodiments, it may be advantageous to use the components of the primary resonant circuit to make measurements of the field component (B₀, B₁, gradients). In some embodiments, one switch can be used, in some other embodiments two or more switches can be used. A non-limiting example of using two switches is given in Fig.5. In this embodiment, a second switch (107) is being used, wherein the second switch (107) is capacitively coupled to the primary circuit (101) and capacitively coupled to the preamplifier (106), wherein the secondary circuit (104) is circuited between the first (103) and second (107) switches. In some examples, the primary resonant circuit can comprise more than 2 capacitors, for instance 3 capacitors (108a, 108b, 108c), denoted also as C2, C21, C22 in Fig.5. This configuration might have multiple advantages. For instance, this configuration might avoid disturbing the functioning of a tank circuit (not denoted in the figure, but comprises of a capacitor 108c and an inductor 104a). Furthermore, the MRI RF receiver assembly design, such as the one of this invention, might pose a need that the material of which the RF receiver assembly is made shall be "short" against Larmor wavelength. Hence, by having the split of the primary circuit 101 into 3 capacitors 108a, 108b, 108c, wherein exemplary, C gets denoted as C, and C2 is splitted into C21 and C22, and respectfully denoted, would allow to increase symmetry or improve detuning properties. For instance, the capacitor 108b (C21) may be used to couple out the signals from the primary resonant circuit 101, whereas the inductor 108c (C22) may be used to turn off the coil if such a need arises. Hence, a maximum reuse of existing components can be achieved.

In the current setting and in some examples, the capacitor (102a, 102b), the capacitor (108c) and the tank circuit (C22 part of 108c and inductor 104a) is connected in series to the preamplifier 106. In this example, selection of the capacitor (105a) allows to tailor the signal to match the input level of the preamp, and hence not to disturb the functioning of the tank circuit. Furthermore, in some examples, the RF receiver assembly (100) can be configured to switch the first switch (103) on/off, thereby switching to tune or detune the current from the primary circuit (101) with the current of the preamplifier (106) by enabling the tank circuit. In detune state, the said series connection can contribute not to disturb the functioning of a tank circuit. The second switch (107) may function to detune the RF signal path when in normal operation mode. In some examples, "normal operation mode" may mean that the secondary resonant circuit (104) is not sensing the signals from the RF receiver assembly 100 operates without the secondary resonant circuit (104).

In some embodiments, the tank circuit can additionally be shielded. One of the advantages this provides is to reduce the B₁ field of the transmit pulse from the primary resonant circuit (101), thereby getting a lower flip angle (the rotation of the net magnetization vector by a radiofrequency pulse relative to the main magnetic field). For instance, when the measured pulse signal coming from the primary resonant circuit (101) is too low this can indicate a broken tank circuit. In some embodiments, the user of an MR machine that uses the RF receiver assemblyof the present application can receive notifications about the functioning of the RF coil. For instance, if the tank circuit described in the present embodiment is faulty, broken or otherwise functioning incorrectly, the user may receive an error message specifying the problem. In some examples, the MR machine may stop operation until the problem is resolved. In that case, the system will stop imaging and report an error message.

In some embodiments, the signal from the primary resonant circuit (101) is tailored to match to the signal of the preamplifier (106). In some other examples, the signal of the tank circuit is matched to the inputof the preamplifier. In some other examples, the signal in the primary resonant circuit (101) may be higher than the signal measured in the preamplifier (106). In some other examples, the signal from the primary resonant circuit (101) may be lower of that signal measured in the preamplifier (106). In the preferred embodiment, the signal from the primary resonant circuit (101) is matched towards the signal of the preamplifier (106). In the context of the present invention "matched" may mean being similar, substantially equal, or complementary to each other. It is to be understood, that by doing so, the signal obtained out of the coil is maximized. For instance, by matching the impedances of RF receiver assembly 100 and the preamplifier, and optimizing for best power or signal transfer the resulting signal is amplified. In some other embodiments, this can be applied to substantially "weak" signals to be expected from the RF receiver assembly 100. In some other embodiments, in case of "strong" signals (e.g. strong signals obtained from the transmit phase), a mismatch might be created so that only a fraction of the signal reaches the preamplifier 106. In this case, the preamplifier is shielded from this excessively strong signal.

In some embodiments, the secondary resonance circuit (104) is configured to measure at least one of: B₀, B₁, predistortions, spin, gradient values. It is to be understood, that other parameters may be measured by the second resonant circuit (104) depending on the specific application and the clinical/technical need of the MR system. Furthermore, an expected artifact level can be calculated based on the measurements, which may be used for correction of the images. This will be further described further in the application. In some examples, an artifact threshold can be applied to the expected artifact level. In some embodiments, this can be done by using a comparator (110).

It is a further aspect of the present invention to have an MRI system (300) that can use the RF receiver assembly(101) of the present application. The MRI system (300) is configured to use any of the embodiments of the present application. The MRI system (300) can be of any type: low-field, conventional 1.5T, 3.0T, ultra-high field MRI system, etc. The RF receiver assembly(100) of the present application can be adapted to operation of any of MRI systems.

In some examples, the MRI system (300) is adapted to adjust the scanning sequences based on the RF receiver assembly (100) measurements. This can be done manually by the user, e.g. by dispaying the results of the measurements and the corresponding recommendations, automatically by the system based on the RF receiver assembly (100) measurements and calculated corrections needed, or a combination of a manual and automatic approaches. For instance, the MRI system (300) can be adapted to automatically adjust the scan sequences imaging parameters based on the measurements of the secondary resonant circuit (104) and the expected artifact level (203). It is to be understood that by measuring the pulse current and/or field components (B₁, B₀, gradients), the system can be configured to calculate the expected artifact level (203) based on these measurements. As a non-limiting example, the system may have specific algorithms that are calculating the expected artifact level based on the specific values of B₀, B₁, gradient fields or other components. The algorithm can be of a type that analyzes the relationships between the field components and the expected artifacts. It is known that certain fields and certain deviations in e.g. the gradient fields produce certain types of artifacts like the flair artifact.

In some examples, a machine learning algorithm can be used for analyzing the expected artifact level (203). The machine learning can be of any types: either supervised or non-supervised machine learning algorithm. In the preferred embodiment, supervised learning algorithms like trained neural networks can be applied. In some embodiments, the trained machine learning algorithms, like the trained neural network, can be used for analyzing and/or adjusting of sequences and/or analyzing measurements of the secondary resonant circuit (104). A practical example would illustrate an exemplary principle of operation. Assume a huge number of scan parameters, which can be selected to a certain extend (input parameters). MRI sequences are prone to field imperfections. This leads to images with artefacts (included in the output parametes). By having additional measurements as described in the patent application, would help to select input paremeters so that the output of the resonant circuit assembly is preferably artefact free. In a test system one can create a training data set by causing field imperfections on intention comprizing input data output data and the distortion measurements. Ideal parameters for artefact reduced images can be determined by expert knowlege, the ideal parameters can be predicted by a trained neural network, or in any other way suitable in the art.

In some examples, machine learning algorithms can be used for retrospective artifact correction. By applying these algorithms, the image quality post-acqusition and image usability can be improved. Examples of machine learning algorithms that can be used are supervised learning algorithms or unsupervised learning algorithms. In the preferred embodiment, supervised learning algorithms are used. It is known that data with a pair of artifact-free and artifact-subject images can typically be complemented by post-processing algorithms that further improve image quality. For instance, unwanted image artefacts can be removed from an image using a neural network. This can be done by matching images subject to artifacts to the images to be either collected via acquisition or generated via simulation. Other methods can be used, such as image denoising, image filtering using Neural Networks (e.g. by generating phase error in k-space), Neural networks in relation to ensemble (to use classification and regression to determine and correct for artifacts), using autoencoders for extracting clean images from noisy images, and others used within the field for artifact correction and/or noise reduction.

In some examples, a Magnetic Resonance Imaging (MRI) system (300) can be used, wherein the measurements of the secondary resonant circuit (104) can be used for at least one of: for calibration of the gradients, predistortion correction or other MR sequence correction purposes. For instance, the system may analyze the B₀, B₁, gradient fields, and based on the measurements perform a fault analysis. For instance, based on e.g. measurements of the gradient fields, determine that the gradients that may require subsequent correction/calibration. It is to be understood that the amount of artifacts produced exceeds a certain clinically-accepted threshold. The person of ordinary skill in the art would understand that the potential sources of artifacts can include: non-ideal hardware characteristics, intrinsic tissue properties and biological behavior, assumptions underlying the data acquisition and image reconstruction processes, poor choice of scanning parameters, and others. It is preferably to improve at least one of these parameters, but even more preferably to improve all of the parameters can be improved. The person of ordinary skill in the art would understand that by e.g. adjusting the scanning protocols based on the fields (Bo, B₁, gradient) measurements, the protocols can carefully be designed/adjusted, gradients calibrated for reducing the image artifact level. For instance, by measuring the gradient non-linearities by mesuring the errors/deviations, the non-linearities can be compensated with other parameters and fields. Another example is the field inhomogenity and artifacts spunning from the field inhomogenity. These artifacts can be corrected by correctly measuring the field map. These examples, show some examples known in the field and that can be applied within the context of the present invention. By correctly measuring the field components, these artifacts can be corrected more efficiently.

It is a further aspect of the present invention to provide a method of operation of a MRI system based on the measurements of the RF coils (100). It is a further aspect of the present invention to provide a computer program comprising instructions which, when the program is executed by a computer, cause the computer to carry out the method of operation of the MRI machine or being configured to run on the MRI system (300) of the present invention. The MRI system (300) of the present invention can comprise a processor, which carries out the method of the present invention. It is a further aspect of the present invention to provide a data carrier signal carrying the computer program of the present invention. It is a further aspect to provide a computer-readable storage medium comprising instructions which, when executed by a computer, cause the computer to carry out steps of the present invention.

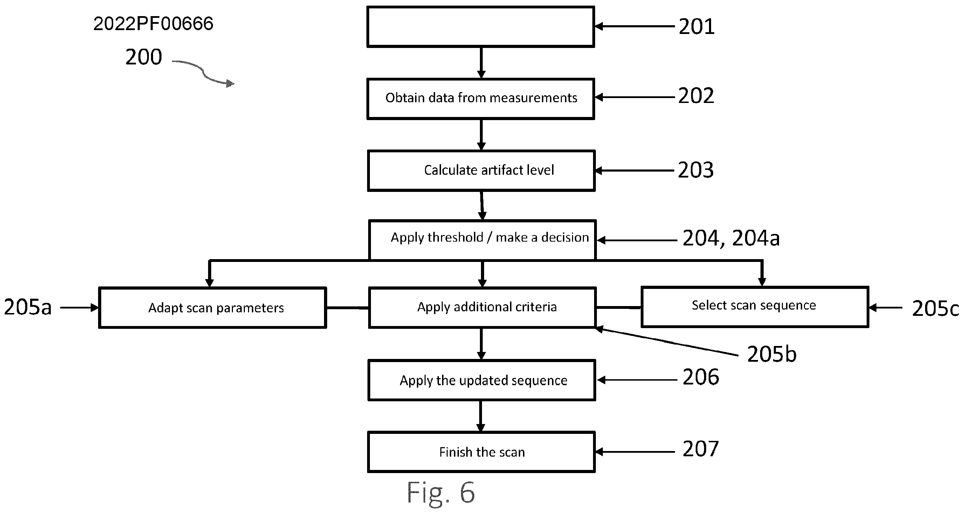

Fig.6 describes an example of adjusting the sequence protocols based on the measurements performed by the RF receiver assembly(100) of the present invention. This is a non-limiting example and other methods are possible in the context of the present invention. For instance, repositioning of the patient, adding cushions, adding shimming elements such as ceramics or passive resonators, removing ferromagnetic parts if detected, etc.

According to the method (200) described in Fig. 6, the imaging sequence is started in step (201). As the next step, the data from the measurements from the RF receiver assembly(100) is obtained in step (202). As was previously discussed, different parameters can be measured and tracked. In the preferred embodiment, the measurements of B₀, B₁, gradient fields can be obtained. Based on the obtained measurements, an artifact level can be calculated in step (203). The artifact level can be configured to measure/include any artifacts that can influence the quality of the images obtained by the MRI machine (300). Preferably, the arfifacts are comprising artifacts that can be produced by B0, B1, gradient fields, such as flame artifacts, backfolding artifacts, and others. In step (204) the user can make a decision on which subsequent step to perform or a combination of steps: to adapt the scan parameters (205a), to apply additional imaging criteria (205b), to select a scan sequence (205c). In some instances an artifact threshold can be applied (204a). The artifact threshold is to be understood as a desired maximum of artifacts that can be acceptable for a specific clinical application. For instance, it can be specified that only mild flame artifacts (e.g. distorting the image not more than 5% or not more than 20%) can be applied. Assuming temporary effects, dynamic thresholds may be applied. For instance, if smoething happens at the beginning of the scan, a better correction can be achieved.

The user can adapt the scan parameters by adapting e.g. the parameters of the scan (205a). This can include, among others, Repetition Time (TR), Echo Time (TE), Flip Angle (FA), Inversion Time (TI), Number of Acquisitions (NA), Field of View (FOV), Slice Thickness (ST), Slice Gap (SG), Phase Encoding (PE), Bandwidth (BW). The user also has an option of applying additional imaging criteria (205b). This can include, among others, TI, T2, relaxation, and others. The user can also select a new scan sequence (205c) since it might be conluded that the particular scanning sequence will produce many artifacts in a specific case. The scan sequence may have other parameters as the initial scan sequence, e.g. different relaxation times, T1/T2, TR, and others. Any combination of steps 205a, 205b, 205c is possible. Upon making the necessary adjustments in at least one of the steps 205a, 205b, 205c, the update sequence can be applied to imaging the patient in step 206. It is to be understood, that the steps 201-206 can be applied in real-time, but also as part of post-processing steps after an initial scan has been performed. When the system obtains clinically accepted imaging parameters, the system finishes the scan in step (207).

In some cases, the method (200) may be based on threshold determination or by directly feeding a trained network with the obtained imaging data, such as adapted scan parameters.

The person of ordinary skill in the art would understand that by applying the RF receiver assembly(100) of the previous embodiments and/or the method (200) to the MRI machine, the following non-limiting advantages can be achieved:
- RF receiver assembly(100) and imaging chain imperfection correction
- Gradient imperfection correction (also patient induced)
- B₀ imperfections
- Using a better switching scheme (e.g. overcoming tank circuits and pin diodes), which enables cheap and reliable circuits without drawbacks on the original image quality.
- Patient safety due to more control on imaging sequences
- No automatic sequence parameter setting based on sensors

The MRI system (300) makes use of a processor to perform the data processing and correction of the sequence protocols. The processor can be implemented in numerous ways, with software and/or hardware, to perform the various functions required. The processor typically employs one or more microprocessors that may be programmed using software (e.g., microcode) to perform the required functions. The processor may be implemented as a combination of dedicated hardware to perform some functions and one or more programmed microprocessors and associated circuitry to perform other functions. Circuitry can be used for connecting the processor to other parts of the MRI machine (300).

Examples of circuitry that may be employed in various embodiments of the present disclosure include, but are not limited to, conventional microprocessors, application specific integrated circuits (ASICs), and field-programmable gate arrays (FPGAs).

The MRI system (300) may have a processor to control the operation of the RF receiver assembly(100) or execute the method of operation of the present application.

In some embodiments, a general or specific purpose computer can be used for carrying out the steps or operating the device of the current invention. For instance, a general purpose computer can be used for carrying out the steps of the method (200) of the current invention, to operate the MRI machine (300), and/or to operate the receiver assembly 100 of the present invention. In some embodiments, a specific purpose computer can be used for carrying out the method of operation of an RF receiver assembly, wherein matching circuit tailors the primary and secondary resonant circuit's respective output signal levels to the preamplifier's dynamic range. In some other embodiments, a specific purpose computer can be used for carrying out the method of operation of an RF receiver 100, wherein the method includes calculation of at least one of: B0, B1, signal distortions, Nuclear Magnetic Resonance signals (NMR signals), gradient field values; and wherein an expected artifact level (203) from measurement data by the secondary resonance circuit.

The described disclosure may be provided as a computer program, or software that may include a computer-readable storage medium having stored thereon instructions, which may be used to program a computer system (or other electronic devices) to perform a process according to the present disclosure. A computer-readable storage medium includes any mechanism for storing information in a form (e.g., software, processing application) readable by a computer. In various implementations, the processor may be associated with one or more storage media such as volatile and non-volatile computer memory, such as the computer-readable storage medium may include, but is not limited to, optical storage medium (e.g., CD-ROM), magneto-optical storage medium, read only memory (ROM), random access memory (RAM), erasable programmable memory (e.g., EPROM and EEPROM), flash memory, or other types of medium suitable for storing electronic instructions.RAM, PROM, EPROM, and EEPROM. The storage media may be encoded with one or more programs that, when executed on one or more processors and/or controllers, perform the required functions. Various storage media may be fixed within a processor or controller or may be transportable, such that the one or more programs stored thereon can be loaded into a processor.

Variations to the disclosed embodiments can be understood and effected by those of ordinary skilled in the art in practicing the claimed invention, from a study of the drawings, the disclosure and the appended claims. In the claims, the word "comprising" does not exclude other elements or steps, and the indefinite article "a" or "an" does not exclude a plurality.

It is understood that one or more of the aforementioned embodiments of the invention may be combined as long as the combined embodiments are not mutually exclusive.

Functions implemented by a processor may be implemented by a single processor or by multiple separate processing units which may together be considered to constitute a "processor". Such processing units may in some cases be remote from each other and communicate with each other in a wired or wireless manner.

The mere fact that certain measures are recited in mutually different dependent claims does not indicate that a combination of these measures cannot be used to advantage.

A computer program may be stored/distributed on a suitable medium, such as an optical storage medium or a solid-state medium supplied together with or as part of other hardware, but may also be distributed in other forms, such as via the Internet or other wired or wireless telecommunication systems. A computer-readable storage medium can be used.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon. Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. A computer readable signal medium may include a propagated data signal with computer executable code embodied therein, for example, in baseband or as part of a carrier wave.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

If the term "adapted to" is used in the claims or description, it is noted the term "adapted to" is intended to be equivalent to the term "configured to". If the term "arrangement" is used in the claims or description, it is noted the term "arrangement" is intended to be equivalent to the term "system", and vice versa.

Any reference signs in the claims should not be construed as limiting the scope.

### LIST OF REFERENCE NUMERALS

100: radiofrequency (RF) coil
101: primary resonant circuit
102a, 102b, 102c: capacitors
103, 103a: first switch
104: secondary resonant circuit
104a, 104b, 104c: inductors
105a, 105b, 105c: capacitors
106: preamplifier
108a, 108b: capacitor
109: inductor
110: comparator
201: start of imaging
202: obtaining data from measurements
203: calculating artifact level/expected artifact level
204: applying a threshold
205a: adapt the scan criteria
205b: apply additional imaging criteria
205c: select a scan sequence
206: update the sequence
207: finish the imaging
300: MRI system

## Claims

1. A radio frequency (RF) receiver assembly (100) for use in a magnetic resonance imaging (MRI) system, the said receiver assembly (100) comprising a primary resonant circuit (101) coupled to a preamplifier (106) via capacitive coupling, and a secondary resonance circuit (104) comprising of at least one inductor (104a) coupled between a first switch (103) and the capacitive coupling, wherein the first switch (103) is circuited between the primary (101) and the secondary (104) resonant circuits, and the preamplifier (106).

2. The RF receiver assembly according to claim 1, wherein the secondary resonant circuit (104) is further including at least one capacitor or attenuator (105a) electrically connected in-series to the inductor (104a).

3. The RF receiver assembly according to claims 1 or 2, wherein the inductor (104a) is positioned inside the primary resonant circuit (101).

4. The RF receiver assembly according to claims 1-3, including in addition to the inductor (104a), at least one and preferably two, additional inductors (104b, 104c) with a matching pair of capacitors (105b, 105c), wherein the inductor 104b is matched to capacitor 105b, and inductor 104c is matched to capacitor 105c, and wherein the capacitors (104b, 104c) are connected in-series to the first switch (103, 103a).

5. The RF receiver assembly according to claims 1-4, provided with a second switch (107) wherein the second switch (107) is capacitively coupled to the primary circuit (101) and capacitively coupled to the preamplifier (106), wherein the secondary circuit (104) is circuited between the first (103) and second (107) switches.

6. The RF receiver assembly according to any of the previous claims, provided with a matching circuit that is configured to match the primary and secondary resonant circuit's respective output signal levels to the preamplifier's dynamic range (106).

7. The RF receiver assembly according to any of the preceding claims, wherein the secondary resonance circuit (104) is configured to measure at least one of: B₀, B₁, signal distortions, Nuclear Magnetic Resonance signals gradient field values; and wherein an expected artifact level (203) is being calculated based on the measurements.

8. The RF receiver assembly according to claim 7, further including a comparator (110) that is configured to compare the expected artifact level (203) to a pre-determined artifact threshold (204).

9. A Magnetic Resonance Imaging (MRI) system (300) comprising a RF receiver assembly (100) as claimed in any one of claims 1-8.

10. A Magnetic Resonance Imaging (MRI) system (300) according to claim 9, wherein the MRI system's (300) scan sequences imaging parameters are adapted to be automatically adjusted based on the measurements of the secondary resonant circuit (104) and the expected artifact level (203).

11. A Magnetic Resonance Imaging (MRI) system (300) according to claim 10, wherein a Machine Learning algorithm, such as a trained Neural Network, can be used for adjusting the MRI sequences and/or analysing measurements of the secondary resonant circuit (104).

12. A Magnetic Resonance Imaging (MRI) system (300) according to claims 9-11, wherein MRI system 300 further comprises a correction unit (301) that is configured to use the measurements of the secondary resonant circuit (104) for at least one of: for calibration of the gradients, predistortion correction or other MR sequence correction purposes.

13. A method for operation of MRI system of claims 9-12 using the RF receiver assembly of claims 1-8.

14. A computer program comprising instructions which, when the program is executed by a computer, cause the computer to carry out the method of claim 13 or being configured to run on the system of claims 9-12.

15. A data carrier signal carrying the computer program of claim 14.
